# EUROPÄISCHE PATENTSCHRIFT

(11) **EP 2 513 655 B1**
(45) Veröffentlichungstag und Bekanntmachung des Hinweises auf die Patenterteilung: **12.10.2016**
(21) Anmeldenummer: 10771106.1
(22) Anmeldetag: 28.10.2010
(51) Int. Cl.: G01R 15/18

(54) **STROMSENSOR MIT SELBSTTESTFUNKTION**
CURRENT SENSOR WITH A SELF-TEST FUNCTION
CAPTEUR DE COURANT AVEC FONCTION D'AUTOTEST

(30) Priorität: 18.12.2009 DE 102009054943
(43) Veröffentlichungstag der Anmeldung: 24.10.2012
(73) Patentinhaber: Samsung SDI Co., Ltd., Gyeonggi-do (KR); Robert Bosch GmbH, 70442 Stuttgart (DE)
(72) Erfinder: TZIVANOPOULOS, Chrysanthos, 70806 Kornwestheim (DE); HASENKOPF, Dirk, 70190 Stuttgart (DE)
(74) Vertreter: Bee, Joachim
(86) Internationale Anmeldenummer: PCT/EP2010/066291
(87) Internationale Veröffentlichungsnummer: WO 2011/072934

(56) Entgegenhaltungen:
- EP-A2- 1 956 384
- WO-A2-2006/113459
- DE-A1- 4 230 939
- DE-A1- 10 053 440
- DE-A1-102008 030 411
- GB-A- 2 228 337

## Beschreibung

### Stand der Technik

Die Erfindung betrifft einen Stromsensor, welcher eine Selbsttestfunktion aufweist, welche sicherstellt, dass der Stromsensor ordnungsgemäß funktioniert, d.h. die vom Stromsensor gemessenen Messwerte zuverlässig sind. Ein solcher Stromsensor eignet sich besonders für kritische Anwendungen wie z.B. in einem Kraftfahrzeug mit einem Batteriemodul und einem elektrischen Antriebsmotor zur Überwachung des Batteriestroms. Ein zweiter Erfindungsaspekt ist auf ein solches Kraftfahrzeug gerichtet, welches beispielsweise als Micro-, Mild- oder VollHybridfahrzeug oder aber als reines Elektrofahrzeug ausgebildet sein kann.

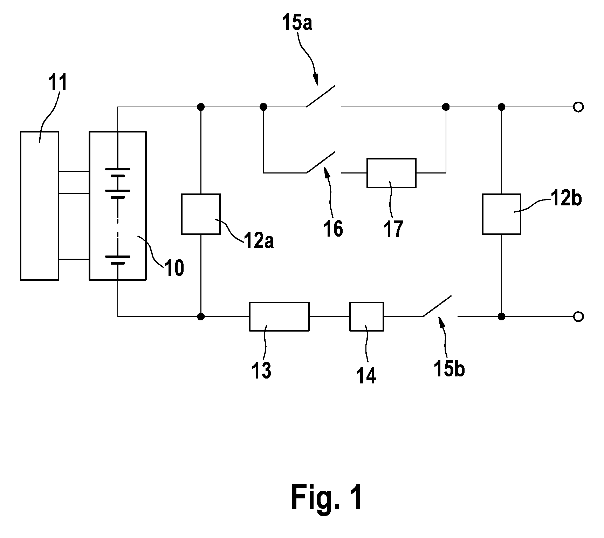

Batteriesysteme zum Einsatz in Kraftfahrzeugen der vorgenannten Typen für das Bereitstellen von Energie für den Antrieb werden zur Unterscheidung von Anlasserbatterien für das Starten eines Verbrennungsmotors "Hochvoltbatterien" genannt. Obwohl Fahrzeuge mit Hochvoltbatterien auf dem Markt noch nicht stark verbreitet sind, hat sich doch bezüglich der Sicherheitskomponenten, welche zur Sicherstellung eines sicheren Betriebs der Hochvoltbatterie gefordert werden, bereits ein gewisser Stand der Technik herausgebildet. Fig. 1 zeigt eine Hochvoltbatterie mit nach heutigem Stand der Technik geforderten Sicherheitskomponenten. Die Hochvoltbatterie 10 verfügt über eine Vielzahl von in Serie geschalteten Batteriezellen zur Erzeugung der gewünschten hohen Ausgangsspannung. Die einzelnen Zellen werden von sogenannten Cell Sense and Control-Einheiten (CSCs) 11 überwacht, um ihren Ladestand zu prüfen und Über- oder Unterladungen der Batteriezellen zu vermeiden. Die Ausgangsspannung der Hochvoltbatterie 10 wird durch eine batterieseitige Gesamtspannungserfassung 12a überwacht. Eine weitere Gesamtspannungserfassung 12b ist antriebsseitig vorgesehen. In einen der beiden Stromwege wird eine Sicherung 13 eingefügt, die bei unzulässig hohen Strömen den Stromkreis auftrennt. Außerdem wird ein Stromsensor zur Batteriestromerfassung in einen der beiden Stromwege eingefügt. In jedem der beiden Stromwege sind zudem Leistungsschütze 15a bzw. 15b vorgesehen, um das Hochvoltbordnetz des Kraftfahrzeuges beispielsweise in einem Notfall oder für eine Wartungsmaßnahme spannungsfrei schalten zu können. Parallel zum Leistungsschütz 15a ist in Fig. 1 außerdem beispielhaft ein Ladestrompfad mit einem Ladeschütz 16 und einem Ladewiderstand 17 zur Begrenzung des Ladestroms vorgesehen.

Insbesondere dem Stromsensor 14 kommt große Bedeutung bei der Überwachung der ordnungsgemäßen Funktion des Hochvoltbatteriesystems zu. Die vom Stromsensor 14 aufgenommene Messgröße dient z.B. dazu, unzulässig hohe Batterieströme zu erkennen und nötigenfalls Gegenmaßnahmen zu ergreifen, um das System in einem sicheren Betriebszustand zu halten. Weiterhin wird aus dem gemessenen Strom durch geeignete Verfahren der aktuelle Ladezustand der Hochvoltbatterie berechnet. Außerdem könnte die Hochvoltbatterie über- oder unterladen werden, was schädliche oder sogar gefährliche Zustände der Hochvoltbatterie nach sich zieht.

Für die Erfassung des Batteriestroms existieren mehrere Verfahren, wie z.B.:
- Messung mittels Spannungsabfall an einem Widerstand (Shunt-Prinzip)
- Messung mittels Transformatoren, basierend auf dem Induktionsprinzip
- Messung mittels Rogowskispulen, basierend auf dem Induktionsprinzip
- Magnetfeldmessung des vom Batteriestrom erzeugten Magnetfeldes, beispielsweise durch Hall-Sensoren, magnetoresistiven Snesoren (AMR, GMR)

An die Batteriestromerfassung werden mehrere Anforderungen gestellt, wie beispielsweise eine ausreichend hohe Genauigkeit und Bandbreite. Wichtig bei Hochvoltbatteriesystemen ist zudem eine ausreichende galvanische Trennung zwischen Hochvoltbordnetz, der Messelektronik und dem Niederspannungsbordnetz (ggf. mit der Anlasserbatterie), um die Fahrzeuginsassen im Falle eines E-lektronikdefektes vor gefährlichen Körperströmen zu schützen.

Gleichzeitig sollen die Kosten für einen Stromsensor möglichst gering sein, um das Gesamtsystem zu marktgerechten Preisen anbieten zu können. Deshalb ist eine Redundanz durch Verwendung mehrere Stromsensoren wirtschaftlich wenig attraktiv, zumal bei einem Einsatz von nur zwei Stromsensoren bei abweichenden Messwerten der beiden Stromsensoren auch nicht klar wäre, welcher Stromsensor korrekt funktioniert und welcher nicht.

EP 1 956 384 A2 offenbart eine Stromsensoranordnung.

Die Erfindung hat das Ziel, die oben genannten Probleme des Standes der Technik zu überwinden.

### Offenbarung der Erfindung

Ein erster Aspekt der Erfindung führt daher einen Stromsensor gemäß Anspruch 1.

Die Erfindung beruht auf der Einsicht, dass eine Plausibilitätsprüfung des vom Stromsensor erfassten Messwertes möglich wird, wenn ein gegebenes Messszenario in bekannter Weise abgeändert und ein in dem abgeänderten Messszenario erfasster zweiter Messwert zum Vergleich herangezogen wird. Die Erfindung sieht daher einen Teststromgenerator vor, der das vom Sensorelement gemessene Magnetfeld im Kern in einem vorbestimmten Maß verändert (beispielsweise vergrößert), so dass überprüft werden kann, ob sich auch die Ausgangsgröße bzw. der aus dieser resultierende Messwert entsprechend verändert. Ändert sich der Messwert nicht so, wie es zu erwarten wäre, ist eine fehlerhafte Strommessung wenigstens wahrscheinlich und es können ggf. entsprechende Sicherheitsmaßnahmen eingeleitet werden. Um größere Sicherheit zu erlangen, können selbstredend auch die Ergebnisse mehrerer Messzyklen abgewartet werden.

Die Prüfeinheit ist ausgebildet, abhängig von dem ersten Messwert ein Paar von Schätzwerten zu bestimmen und eine Information, die ein ordnungsgemäßes Funktionieren des Stromsensors anzeigt, auszugeben, wenn der zweite Messwert innerhalb eines von dem Paar von Schätzwerten definierten Intervalls liegt. Dies trägt der Tatsache Rechnung, dass sich zwischen der ersten Messung und der Prüfmessung die Messgröße selbst verändern kann, etwa weil ein geänderter Betriebszustand eines Kraftfahrzeuges vorliegt, in dem der Stromsensor beispielsweise eingesetzt wird. Da sich die Messgröße aber nur in endlicher Geschwindigkeit ändern kann und diese Änderungsgeschwindigkeit beispielsweise durch Induktivitäten im Hochvoltbordnetz begrenzt ist, kann eine Spanne bestimmt oder vorgegeben werden, innerhalb derer der zweite Messwert trotz einer angenommenen maximalen Änderungsgeschwindigkeit der Messgröße liegen muss. Das Paar von Schätzwerten wird anhand der Größe des ersten Messwertes veränderlich von der Prüfeinheit bestimmt, so dass beispielsweise Nichtlinearitäten in der Messung oder je nach Betriebszustand unterschiedliche Änderungsgeschwindigkeiten der Messgröße berücksichtigt werden können.

Der Teststromgenerator ist bevorzugt ausgebildet, ein Teststromsignal mit einer Amplitude von wenigstens einem vorgegebenen maximalen zu messenden Strom in dem Leiter geteilt durch eine Anzahl von Wicklungen der Prüfwicklung um den Kern zu erzeugen. Auf diese Weise ist es nicht notwendig, ein Teststromsignal mit einer großen Amplitude zu erzeugen, um den gesamten Messbereich des Stromsensors abdecken zu können, was die Leistungsaufnahme der zusätzlichen Schaltungsmaßnahmen der Erfindung minimiert.

Der Teststromgenerator kann ausgebildet sein, ein stufenförmiges, sägezahnförmiges, dreieckförmiges, sinusförmiges oder rechteckförmiges Teststromsignal zu erzeugen.

Wegen der einfachen Signalverarbeitung wird ein Sensorelement bevorzugt, das ausgebildet ist, eine Ausgangsspannung als Ausgangsgröße zu erzeugen. Der Stromsensor weist vorzugsweise einen Verstärker und einen A/D-Umsetzer auf, wobei der Verstärker ausgebildet ist, die Ausgangsspannung zu verstärken und an den A/D-Umsetzer auszugeben.

Alle Ausführungsformen des Stromsensors können eine um den Kern angeordnete Kompensationswicklung und einer Kompensationsschaltung aufweisen, wobei die Kompensationsschaltung ausgebildet ist, abhängig von einem zu einem vor dem ersten Zeitpunkt liegenden dritten Zeitpunkt gemessenen dritten Messwert einen Kompensationsstrom zu erzeugen und während des ersten Zeitpunktes und des zweiten Zeitpunktes an die Kompensationswicklung auszugeben. Dadurch wird es möglich, ein Kompensationsmagnetfeld im Kern zu erzeugen, um die Messgröße in einen Bereich zu verschieben, in dem das Sensorelement besonders hohe Linearität besitzt.

Ein zweiter Erfindungsaspekt betrifft ein Kraftfahrzeug mit einem elektrischen Antriebsmotor, einem mit dem elektrischen Antriebsmotor verbundenen Batteriemodul und einem Stromsensor zum Messen eines zwischen dem Batteriemodul und dem elektrischen Antriebsmotor fließenden Stromes. Erfindungsgemäß ist der Stromsensor ein Stromsensor gemäß dem ersten Aspekt der Erfindung.

Bevorzugt wird ein Kraftfahrzeug, bei dem das Batteriemodul mit dem elektrischen Antriebsmotor über wenigstens ein Schütz verbunden ist, welches ausgebildet ist, das Batteriemodul vom elektrischen Antriebsmotor auf ein Prüfsignal vom Stromsensor hin, welches ein nicht ordnungsgemäßes Funktionieren des Stromsensors anzeigt, abzutrennen. Ein dritter Aspekt der Erfindung führt ein Verfahren zum Messen eines Stromes gemäß Anspruch 9.

### Zeichnungen

### Kurzbeschreibung der Abbildungen

Die Erfindung wird im Folgenden anhand von Abbildungen von Ausführungsbeispielen näher erläutert. Es zeigen:
- Fig. 1: eine Hochvoltbatterie mit Sicherheitskomponenten;
- Fig. 2: einen Stromsensor gemäß der Erfindung; und
- Fig. 3: Beispiele für mögliche Teststromsignale.

### Ausführliche Beschreibung der Abbildungen

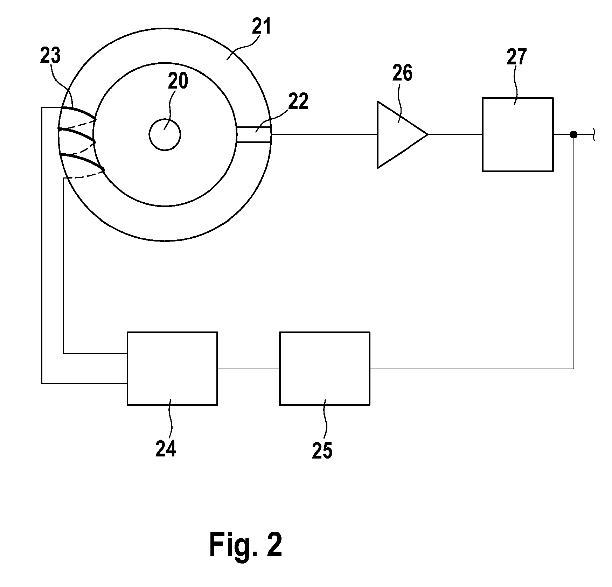

Fig. 2 zeigt einen Stromsensor gemäß der Erfindung. Um einen entlang der Bildsenkrechten verlaufenden elektrischen Leiter 20, in dem der zu messende Strom fließt, ist ein Kern 21 angeordnet, in dem sich ein von dem im Leiter 20 fließenden Strom erzeugtes Magnetfeld aufbaut. An dem Kern 21 ist ein Sensorelement 22 angeordnet, welches eine von dem Magnetfeld abhängige Ausgangsgröße erzeugt und zur weiteren Verarbeitung ausgibt. In Fig. 2 beispielhaft gezeigt sind ein Verstärker 26 und ein Analog-Digital-Umsetzer 27, welche eine elektrische Größe ausgegebene Ausgangsgröße verstärken und in einen digitalen Messwert umsetzen und so als Messeinheit fungieren. Die Messeinheit kann jedoch auch in das Sensorelement 22 integriert sein. Anstelle des Verstärkers 26 und des Analog-Digital-Umsetzers 27 können aber auch andere Komponenten zur Verarbeitung der Ausgangsgröße des Sensorelementes 22 vorgesehen sein.

Um den Kern 21 ist außerdem eine Prüfwicklung 23 mit einer Anzahl wₚ von Windungen angeordnet, welche mit einem Teststromgenerator 24 verbunden ist. Der Teststromgenerator 24 weist einen mit einer Prüfeinheit 25 verbundenen Steuereingang für ein Steuersignal auf und ist ausgebildet, auf das Steuersignal hin ein Teststromsignal zu erzeugen und an die Prüfwicklung 23 auszugeben. Die Prüfwicklung 23 generiert so ein zusätzliches Magnetfeld im Kern 21, welches sich mit dem vom im Leiter 20 fließenden Strom erzeugten Magnetfeld überlagert, wodurch sich bei ordnungsgemäßem Funktionieren des Stromsensors auch die Ausgangsgröße des Sensorelementes 22 entsprechend verändern muss. Die Prüfeinheit 25 ist mit dem Sensorelement 22 über die Messeinheit verbunden und kann nun für eine gegebene Betriebsbedingung eine Messung bei inaktivem Teststromgenerator 24 mit einer solchen bei aktivem Teststromgenerator 24 vergleichen und so prüfen, ob sich die Ausgangsgröße des Sensorelementes 22 erwartungsgemäß mit dem Teststromsignal des Teststromgenerators 24 ändert. Im Beispiel der Fig. 2 ist die Prüfeinheit 25 mit dem Sensorelement 22 über den Verstärker 26 und den Analog-Digital-Umsetzer 27, welche als Messeinheit fungieren, verbunden, es ist jedoch auch möglich, die Prüfeinheit 25 direkt mit dem Sensorelement 22 zu verbinden oder die Messeinheit in die Prüfeinheit 22 zu integrieren. Die Funktion der Prüfeinheit 25 könnte bei Verwendung des Analog-Digital-Umsetzers 27 rein digital aufgebaut sein und von einem sonstigen im System vorhandenen Mikrokontroller oder dergleichen übernommen werden, was den Aufwand für zusätzliche Komponenten minimiert.

Um einen möglichst großen Teil der Übertragungskennlinie des Stromsensors überprüfen zu können, sollte der Prüfstrom den gleichen Bereich [Bmin, Bmax] an Induktionsdichte B im Kern 21 abdecken können, die der Strom I im Leiter 20 im Bereich [Imin, Imax] erzeugt. Durch die frei wählbare Windungszahl wₚ der Prüfwicklung 23 braucht der Teststromgenerator 24 lediglich einen Teststromsignal im Bereich [Imin/wₚ, Imax/wₚ] erzeugen zu können, was die technische Realisierung insbesondere bei großen Strömen I im Leiter 20 erheblich vereinfacht.

Um das Prüfverfahren auch bei veränderlichen Strömen im Leiter 20 anwenden zu können, kann ausgehend von einem zu einem Zeitpunkt t0 gemessenen ersten Messwert A₁ ein Paar von Schätzwerten berechnet werden, zwischen denen ein bei aktivem Teststromgenerator 24 an einem um einen Zeitraum ΔT späteren Zeitpunkt t1 aufgenommener zweiter Messwert A₂ erwartungsgemäß liegen muss (t1 = t0 + ΔT). Da eine maximale Änderungsgeschwindigkeit des Stromes I aus den für eine jeweilige Umgebung geltenden elektrischen Parametern bestimmt und ΔT in praktischen technischen Realisierungen sehr klein gewählt werden kann, lässt sich eine maximale Änderung ΔA der Ausgangsgröße A des Sensorelementes 22 (oder der sich dem Sensorelement 22 anschließenden Signalverarbeitungskette) bestimmen, die sich durch die maximal mögliche Änderung ΔI des Stromes I im Zeitraum ΔT ergeben kann. Der zweite Messwert kann nun unter zusätzlicher Berücksichtigung von ΔA beurteilt werden und sollte bei ordnungsgemäßem Betrieb zwischen den für einen Gesamtstrom von Iₑₛₜ₁ = I + ΔI + Iₜₑₛₜ bzw. Iₑₛₜ₂ = I - ΔI + Iₜₑₛₜ zu erwartenden Ausgangsgrößen Aₑₛₜ₁ und Aₑₛₜ₂ liegen. Bei einem linearen Verhalten des Stromsensors können die zu erwartenden Ausgangsgrößen Aₑₛₜ₁ und Aₑₛₜ₂ durch einfache Extrapolation bestimmt werden, ansonsten könnte eine in der Prüfeinheit beispielsweise als Tabelle hinterlegte Kennlinie des Stromsensors benutzt werden.

Generell ist es möglich, ein Teststromsignal konstanter Größe (Amplitude) und konstanten Verlaufs zu verwenden. Bessere Ergebnisse werden jedoch erzielt, wenn die Größe des Teststromsignals variiert oder auch abhängig vom ersten Messwert bestimmt wird. Auch können weitere Messwerte zur Prüfung bei jeweils verändertem Teststromsignal herangezogen werden. So kann ein Teststromsignal einen größeren Wertebereich überstreichen und während des Überstreichens des Wertebereichs eine Mehrzahl an Messungen bzw. Messpaaren von ersten und zweiten Messwerten durchgeführt werden, um das Ergebnis der Diagnose zu verbessern. In einem solchen Verfahren kann es auch möglich sein, beispielsweise durch Alterung von Komponenten des Stromsensors verursachte Veränderungen der Kennlinie des Stromsensors aufzuspüren.

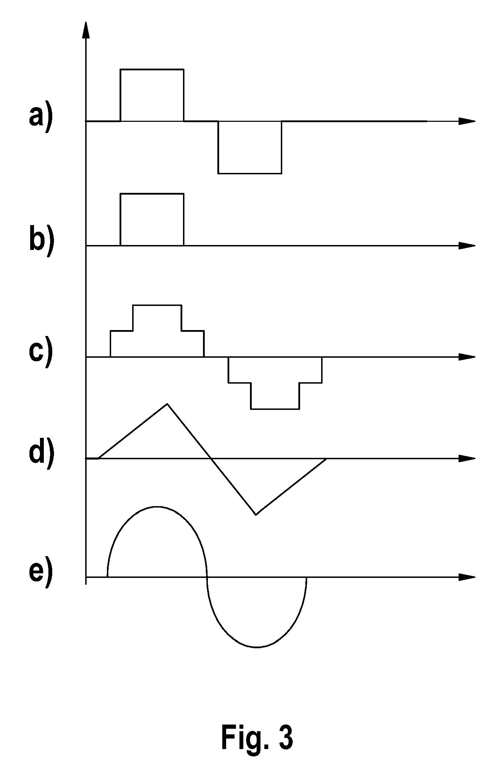

Fig. 3 zeigt einige Beispiele für mögliche Teststromsignale. Die Teststromsignale können, wie in den Diagrammen a) bzw. b) dargestellt, bipolar oder unipolar rechteckförmig sein, stufenförmig (Diagramm c)), sägezahnförmig, dreieckförmig (Diagramm d)) oder sinusförmig (Diagramm e)). Alternativ sind viele andere Formen vorstellbar.

Das Messverfahren der Erfindung kann prinzipiell in jedem Betriebszustand durchgeführt werden, bei Einsatz des Stromsensors in einem Kraftfahrzeug also vor, während oder nach der Fahrt. Die Prüfsequenz kann dabei abhängig vom momentan vorliegenden Strom ausgelöst werden, um für einen Strom eine Prüfung durchzuführen, für den bereits ein längerer Zeitraum seit der letzten Prüfung vergangen ist, so dass ein möglichst großer Anteil des gesamten Intervalls [Imin, Imax] an möglichen Eingangsstromwerten des Stromsensors überprüft wird.

## Patentansprüche

1. Ein Stromsensor (14) zum Messen eines Stromes in einem Leiter (20) anhand eines von dem Strom erzeugten Magnetfeldes, der Stromsensor (20) wenigstens aufweisend:
einen um den Leiter (20) angeordneten Kern (21), vorzugsweise aus einem magnetischen Material;
ein an dem Kern (21) angeordnetes Sensorelement (22), welches ausgebildet ist, eine von einem Magnetfeld in dem Kern (21) abhängige Ausgangsgröße zu erzeugen;
eine Messeinheit, welche ausgebildet ist, die Ausgangsgröße zu erfassen und einen Messwert des Stromes in dem Leiter (20) aus der erfassten Augangsgröße abzuleiten;
eine um den Kern (21) angeordnete Prüfwicklung (23), und
einen mit der Prüfwicklung (23) verbundenen Teststromgenerator (24), welcher ausgebildet ist, auf ein Steuersignal hin ein Teststromsignal vorbestimmter Amplitude zu erzeugen und an die Prüfwicklung (23) auszugeben,
**gekennzeichnet durch**
eine Prüfeinheit (25), die mit der Messeinheit und dem Teststromgenerator (24) verbunden und ausgebildet ist, den Stromsensor zu steuern, eine Prüfsequenz durchzuführen, bei der die Prüfeinheit (25) an einem ersten Zeitpunkt einen ersten Messwert von der Messeinheit entgegen nimmt,
an einem auf den ersten Zeitpunkt folgenden zweiten Zeitpunkt das Steuersignal an den Teststromgenerator (24) ausgibt,
am zweiten Zeitpunkt oder an einem auf den zweiten Zeitpunkt folgenden dritten Zeitpunkt einen zweiten Messwert von der Messeinheit entgegen nimmt,
den ersten Messwert mit den zweiten Messwert vergleicht, und abhängig von einem Ergebnis des Vergleichs des ersten und des zweiten Messwerts eine Information darüber, ob der Stromsensor (14) ordnungsgemäß funktioniert, als Prüfsignal ausgibt,
wobei die Prüfeinheit ausgebildet ist, abhängig von dem ersten Messwert und einer maximalen Änderungsgeschwindigkeit des Stromes **durch** den Leiter (20) ein Paar von Schätzwerten zu bestimmen und eine Information, die ein ordnungsgemäßes Funktionieren des Stromsensors anzeigt, auszugeben, wenn der zweite Messwert innerhalb eines von dem Paar von Schätzwerten definierten Intervalls liegt.

2. Der Stromsensor (14) von Anspruch 1, bei dem der Teststromgenerator (24) ausgebildet ist, ein Teststromsignal mit einer Amplitude von wenigstens einem vorgegebenen maximalen zu messenden Strom in dem Leiter (20) geteilt durch eine Anzahl von Wicklungen der Prüfwicklung (23) um den Kern (21) zu erzeugen.

3. Der Stromsensor (14) von einem der vorhergehenden Ansprüche, bei dem der Teststromgenerator (24) ausgebildet ist, ein stufenförmiges, sägezahnförmiges, dreieckfömiges, sinusförmiges oder rechteckförmiges Teststromsignal zu erzeugen.

4. Der Stromsensor (14) von einem der vorhergehenden Ansprüche, bei dem das Sensorelement (22) ausgebildet ist, eine Ausgangsspannung als Ausgangsgröße zu erzeugen.

5. Der Stromsensor (14) von Anspruch 4, bei dem die Messeinheit einen Verstärker (26) und einen A/D-Umsetzer (27) aufweist, wobei der Verstärker (26) ausgebildet ist, die Ausgangsspannung zu verstärken und an den A/D-Umsetzer (27) auszugeben.

6. Der Stromsensor (14) von einem der vorhergehenden Ansprüche, mit einer um den Kern (21) angeordneten Kompensationswicklung und einer Kompensationsschaltung, welche ausgebildet ist, einen Kompensationsstrom zu erzeugen und an die Kompensationswicklung auszugeben.

7. Ein Kraftfahrzeug mit einem elektrischen Antriebsmotor, einem mit dem elektrischen Antriebsmotor verbundenen Batteriemodul (10) und einem Stromsensor (14) zum Messen eines zwischen dem Batteriemodul (10) und dem elektrischen Antriebsmotor fließenden Stromes, **dadurch gekennzeichnet, dass** der Stromsensor (14) ein Stromsensor (14) gemäß einem der vorhergehenden Ansprüche ist.

8. Das Kraftfahrzeug von Anspruch 7, bei dem das Batteriemodul (10) mit dem elektrischen Antriebsmotor über wenigstens ein Schütz (15a, 15b) verbunden ist, welches ausgebildet ist, das Batteriemodul (10) vom elektrischen Antriebsmotor auf ein Prüfsignal vom Stromsensor (14) hin, welches ein nicht ordnungsgemäßes Funktionieren des Stromsensors (14) anzeigt, abzutrennen.

9. Verfahren zum Messen eines Stromes in einem Leiter (20) anhand eines von dem Strom erzeugten Magnetfeldes, wobei ein Stromsensors gemäß dem Anspruch 6 verwendet wird und wobei das Verfahren aufweist:
an einem ersten Zeitpunkt, Entgegennehmen mittels der Prüfeinheit (25), eines ersten Messwerts von der Messeinheit,
an einem auf den ersten Zeitpunkt folgenden zweiten Zeitpunkt, Ausgeben, aus der Prüfeinheit, des Steuersignals an den Teststromgenerator (24),
am zweiten Zeitpunkt oder an einem auf den zweiten Zeitpunkt folgenden dritten Zeitpunkt, Entgegennehmen mittels der Prüfeinheit (25) eines zweiten Messwerts von der Messeinheit,
Vergleichen, mittels der Prüfeinheit (25), des ersten Messwerts mit dem zweiten Messwert,
abhängig von einem Ergebnis des Vergleichs des ersten und des zweiten Messwerts, Ausgeben mittels der Prüfeinheit (25) einer Information darüber, ob der Stromsensor (14) ordnungsgemäß funktioniert, als Prüfsignal, wobei die Prüfeinheit abhängig von dem ersten Messwert und einer maximalen Änderungsgeschwindigkeit des Stromes durch den Leiter (20) ein Paar von Schätzwerten bestimmt und eine Information, die ein ordnungsgemäßes Funktionieren des Stromsensors anzeigt, ausgibt, wenn der zweite Messwert innerhalb eines von dem Paar von Schätzwerten definierten Intervalls liegt,
Erzeugen eines Kompensationsstroms mittels der Kompensationsschaltung, abhängig von einem zu einem vor dem ersten Zeitpunkt liegenden vierten Zeitpunkt gemessenen dritten Messwert, und
Ausgeben des Kompensationsstroms mittels der Kompensationsschaltung an die Kompensationswicklung während des ersten Zeitpunktes und des zweiten Zeitpunktes.

## Claims

1. Current sensor (14) for measuring a current in a conductor (20) using a magnetic field generated by the current, the current sensor (20) at least having:
a core (21) which is arranged around the conductor (20) and is preferably made of a magnetic material;
a sensor element (22) which is arranged on the core (21) and is designed to generate an output variable which is dependent on a magnetic field in the core (21);
a measuring unit which is designed to detect the output variable and to derive a measured value of the current in the conductor (20) from the detected output variable;
a test winding (23) which is arranged around the core (21), and
a test current generator (24) which is connected to the test winding (23) and is designed to generate a test current signal of a predetermined amplitude in response to a control signal and to output said test current signal to the test winding (23),
**characterized by**
a testing unit (25) which is connected to the measuring unit and to the test current generator (24) and is designed to control the current sensor, to carry out a testing sequence in which the testing unit (25) receives a first measured value from the measuring unit at a first point in time,
outputs the control signal to the test current generator (24) at a second point in time following the first point in time,
receives a second measured value from the measuring unit at the second point in time or at a third point in time following the second point in time,
compares the first measured value with the second measured value, and, on the basis of a result of the comparison of the first and second measured values, outputs an item of information relating to whether the current sensor (14) is operating properly as a test signal,
wherein the testing unit is designed to determine a pair of estimated values on the basis of the first measured value and a maximum rate of change of the current through the conductor (20) and to output an item of information which indicates proper operation of the current sensor if the second measured value is within a range defined by the pair of estimated values.

2. Current sensor (14) from Claim 1, in which the test current generator (24) is designed to generate a test current signal with an amplitude of at least one predefined maximum current to be measured in the conductor (20) divided by a number of windings of the test winding (23) around the core (21).

3. Current sensor (14) from one of the preceding claims, in which the test current generator (24) is designed to generate a stepped, sawtooth, triangular, sinusoidal or square-wave test current signal.

4. Current sensor (14) from one of the preceding claims, in which the sensor element (22) is designed to generate an output voltage as an output variable.

5. Current sensor (14) from Claim 4, in which the measuring unit has an amplifier (26) and an A/D converter (27), the amplifier (26) being designed to amplify the output voltage and to output it to the A/D converter (27).

6. Current sensor (14) from one of the preceding claims, having a compensation winding which is arranged around the core (21) and a compensation circuit which is designed to generate a compensation current and to output said current to the compensation winding.

7. Motor vehicle having an electrical drive motor, a battery module (10) connected to the electrical drive motor and a current sensor (14) for measuring a current flowing between the battery module (10) and the electrical drive motor, **characterized in that** the current sensor (14) is a current sensor (14) as claimed in one of the preceding claims.

8. Motor vehicle from Claim 7, in which the battery module (10) is connected to the electrical drive motor via at least one contactor (15a, 15b) which is designed to disconnect the battery module (10) from the electrical drive motor in response to a test signal from the current sensor (14), which signal indicates improper operation of the current sensor (14).

9. Method for measuring a current in a conductor (20) using a magnetic field generated by the current, a current sensor according to Claim 6 being used and the method comprising:
receiving a first measured value from the measuring unit by means of the testing unit (25) at a first point in time,
outputting the control signal to the test current generator (24) from the testing unit at a second point in time following the first point in time,
receiving a second measured value from the measuring unit by means of the testing unit (25) at a second point in time or at a third point in time following the second point in time,
comparing the first measured value with the second measured value by means of the testing unit (25), outputting an item of information relating to whether the current sensor (14) is operating properly as a test signal by means of the testing unit (25) on the basis of a result of the comparison of the first and second measured values, the testing unit determining a pair of estimated values on the basis of the first measured value and a maximum rate of change of the current through the conductor (20) and outputting an item of information which indicates that the current sensor is operating properly if the second measured value is within a range defined by the pair of estimated values,
generating a compensation current by means of the compensation circuit on the basis of a third measured value measured at a fourth point in time before the first point in time, and
outputting the compensation current to the compensation winding by means of the compensation circuit during the first and second points in time.

## Revendications

1. Capteur de courant (14) destiné à mesurer un courant dans un conducteur (20) au moyen d'un champ magnétique généré par le courant, le capteur de courant (20) possédant au moins
un noyau (21), de préférence en un matériau magnétique, disposé autour du conducteur (20) ;
un élément détecteur (22) disposé sur le noyau (21), lequel est configuré pour générer une grandeur de sortie dépendante d'un champ magnétique dans le noyau (21) ;
une unité de mesure qui est configurée pour collecter la grandeur de sortie et dériver de la grandeur de sortie collectée une valeur mesurée du courant dans le conducteur (20) ;
un enroulement de contrôle (23) disposé autour du noyau (21), et
un générateur de courant d'essai (24) relié à l'enroulement de contrôle (23), lequel est configuré pour, en présence d'un signal de commande, générer un signal de courant d'essai ayant une amplitude prédéfinie et le délivrer à l'enroulement de contrôle (23),
**caractérisé par**
une unité de contrôle (25) qui est reliée à l'unité de mesure et au générateur de courant d'essai (24) et qui est configurée pour commander le capteur de courant, exécuter une séquence de contrôle lors de laquelle l'unité de contrôle (25) reçoit une première valeur mesurée de la part de l'unité de mesure à un premier instant,
délivre le signal de commande au générateur de courant d'essai (24) à un deuxième instant qui suit le premier instant,
reçoit une deuxième valeur mesurée de la part de l'unité de mesure au deuxième instant ou à un troisième instant qui suit le deuxième instant,
compare la première valeur mesurée à la deuxième valeur mesurée et, en fonction du résultat de la comparaison de la première et de la deuxième valeur mesurée, délivre en tant que signal de contrôle une information indiquant si le capteur de courant (14) fonctionne normalement,
l'unité de contrôle étant configurée pour déterminer une paire de valeurs estimées en fonction de la première valeur mesurée et d'une vitesse de variation maximale du courant à travers le conducteur (20), et pour délivrer une information qui indique un fonctionnement normal du capteur de courant lorsque la deuxième valeur mesurée se trouve à l'intérieur d'un intervalle défini par la paire de valeurs estimées.

2. Capteur de courant (14) selon la revendication 1, avec lequel le générateur de courant d'essai (24) est configuré pour générer un signal de courant d'essai ayant une amplitude au moins égale à un courant maximum prédéfini à mesurer dans le conducteur (20) divisé par un nombre d'enroulements de l'enroulement de contrôle (23) autour du noyau (21).

3. Capteur de courant (14) selon l'une des revendications précédentes, avec lequel le générateur de courant d'essai (24) est configuré pour générer un signal de courant d'essai échelonné, en dents de scie, triangulaire, sinusoïdal ou rectangulaire.

4. Capteur de courant (14) selon l'une des revendications précédentes, avec lequel l'élément détecteur (22) est configuré pour générer une tension de sortie en tant que grandeur de sortie.

5. Capteur de courant (14) selon la revendication 4, avec lequel l'unité de mesure possède un amplificateur (26) et un convertisseur A/N (27), l'amplificateur (26) étant configuré pour amplifier la tension de sortie et la délivrer au convertisseur A/N (27).

6. Capteur de courant (14) selon l'une des revendications précédentes, comprenant un enroulement de compensation disposé autour du noyau (21) et un circuit de compensation qui est configuré pour générer un courant de compensation et le délivrer à l'enroulement de compensation.

7. Véhicule automobile équipé d'un moteur de propulsion électrique, d'un module de batterie (10) relié au moteur de propulsion électrique et d'un capteur de courant (14) destiné à mesurer un courant qui circule entre le module de batterie (10) et le moteur de propulsion électrique, **caractérisé en ce que** le capteur de courant (14) est un capteur de courant (14) selon l'une des revendications précédentes.

8. Véhicule automobile selon la revendication 7, avec lequel le module de batterie (10) est relié au moteur de propulsion électrique par le biais d'au moins un contacteur (15a, 15b) qui est configuré pour déconnecter le module de batterie (10) du moteur de propulsion électrique en présence d'un signal de contrôle du capteur de courant (14) qui indique un fonctionnement anormal du capteur de courant (14).

9. Procédé de mesure d'un courant dans un conducteur (20) au moyen d'un champ magnétique généré par le courant, un capteur de courant (20) selon la revendication 6 étant utilisé et le procédé comprenant les étapes suivantes :
à un premier instant, réception d'une première valeur mesurée de la part de l'unité de mesure au moyen de l'unité de contrôle (25),
à un deuxième instant qui suit le premier instant, délivrance, par l'unité de contrôle, du signal de commande au générateur de courant d'essai (24) au deuxième instant ou à un troisième instant qui suit le deuxième instant, réception d'une deuxième valeur mesurée de la part de l'unité de mesure au moyen de l'unité de contrôle (25),
comparaison, au moyen de l'unité de contrôle (25), de la première valeur mesurée avec la deuxième valeur mesurée,
en fonction du résultat de la comparaison de la première et de la deuxième valeur mesurée, délivrance au moyen de l'unité de contrôle (25) d'une information indiquant si le capteur de courant (14) fonctionne normalement, sous la forme d'un signal de contrôle, l'unité de contrôle déterminant une paire de valeurs estimées en fonction de la première valeur mesurée et d'une vitesse de variation maximale du courant à travers le conducteur (20), et délivrant une information qui indique un fonctionnement normal du capteur de courant lorsque la deuxième valeur mesurée se trouve à l'intérieur d'un intervalle défini par la paire de valeurs estimées,
génération d'un courant de compensation au moyen du circuit de compensation, en fonction d'une troisième valeur mesurée à un quatrième instant qui se trouve avant le premier instant, et
délivrance du courant de compensation au moyen du circuit de compensation à l'enroulement de compensation pendant le premier instant et le deuxième instant.
